# EUROPEAN PATENT APPLICATION

(11) **EP 0 712 178 A2**
(43) Date of publication of application: **15.05.1996**
(21) Application number: 95115997.9
(22) Date of filing: 11.10.1995
(51) Int. Cl.: H01R 13/633

(54) **Ejector for right angle board mount connector**

(30) Priority: 21.10.1994 JP 256709/94
(71) Applicant: MINNESOTA MINING AND MANUFACTURING COMPANY, St. Paul, Minnesota 55133-3427 (US)
(72) Inventor: Shimizu, Tatsuyoshi, c/o Sumitomo 3M Limited, Tokyo 158 (JP)
(74) Representative: Hilleringmann, Jochen, Dipl.-Ing.

(57) **Abstract**

To provide a direct card pushing type of a connector which enables a high dense on-board mounting to be effected, and makes it easy to assemble the parts thereof, while the number of the parts is minimized.

The connector comprises a connector body of a heat insulating material (100, 200) and an ejector which can be assembled therewith by only an action taken to descend the ejector in a vertical direction to thereby cover the connector body. A body (300) of the ejector has opposite side walls (310, 320) and a top wall (330). A sleeve means (350), in which a rod (500) forming a push button means is disposed, is integrated with one of the side walls (320) at the outside thereof. A lever is pivotally mounted to the top wall with its end being linked with the rod and its other end forming a card pushing means (410). The opposite side walls of the ejector body and a housing (200) of the connector body are provided with positioning means (211, 221; 321, 311) for positioning the ejector body (300) relative to the housing and detent means (215, 225; 325, 315) for inter-lock both the members with each other.

## Description

### Field of the Invention

The present invention relates to a connector for a PC card, particularly a connector having a direct push type of a card disengaging mechanism provided therein.

### Background of the Invention

A connector for a PC card as disclosed in JP Unexamined Utility Model Publication No. 2-41378 is an assembly of not less than six separate parts. Main parts of the connector are a connector element integral with a housing, so called "insulator", an ejector composed of a body and a sleeve integral therewith, a card carrying plate, a lever having a pivot located between opposite ends thereof, a rod forming a push button means at a free end thereof and a spring biasing the rod. The lever is linked with the other end of the rod at its end, is linked with the card carrying plate at its other end, and is mounted to the ejector body at the pivot for rotation. The ejector body is inserted in a direction of card insertion to inter-lock with the housing. The card carrying plate is slidably disposed in the ejector body and the housing when assembled. The rod is disposed with the spring in the sleeve. The connector assembled as above has a card disengaging mechanism provided therein, wherein when the rod is pushed against the spring, the card carrying plate is pushed by the lever being guided by a groove formed in the ejector body, to thereby have the card on the plate disengaged from the connector element. This mechanism may be called "an indirect push type of a card disengaging mechanism", since the card is disengaged by not have the lever push the card per se but have the lever push the plate directly.

Another kind of connectors are disclosed in JP Unexamined Utility Model Publication No. 5-55258. Such a connector is an assembly of not less than five separate parts. Main parts of the connector correspond to those of the first mentioned conventional connector, but with the spring and the card carrying plate being omitted. It is, however, noted that the ejector of the second connector comprises two separate frames, one of which has an integral sleeve. The spring may be provided as an optional part. The two frames are engageable with the housing in the card insertion direction. Both the connector element and housing are integrated to have a space gap or groove defined therebetween. The lever is mounted to the housing at the pivot for rotation with its end being linked with the rod. The other free end of the lever is raised to form a card pushing means. The second connector is different from the first one in that it has a direct push type of the card disengaging mechanism. That is, with the second connector, the lever is pivoted, while its card pushing means is passing through the space gap between the connector element and the housing, to have the card pushing means push the card directly to thereby disengage the card from the connector element.

The on-board mounting of the connector is carried out in such a manner that at least the connector element integral with the housing is placed at a predetermined location of the circuit board, and the terminals of the connector element are then brazed to corresponding terminals of the board. Both the connector element and housing are subjected to heating during the brazing treatment, and thus both the elements must be made of a heat insulating plastic material. In this connection, if some of the ejector parts must be assembled with the housing prior to the on-board mounting, these parts must be made of heat insulating materials. In order to avoid such necessity, it is desired to design the connector so that the ejector parts may be assembled with the housing after the on-board mounting of the connector element integral with the housing. However, as a matter of course, even if this is a case, the on-board mounting of the connector requires an extra space for the ejector body other than the space occupied by both the connector element and housing on the board lying in a horizontal operation plane. Further, with the above mentioned first and second connectors, an additional space other than the above extra space is required. This is because the assembling of the ejector with the housing on the operation plane requires an operation space for allowing the ejector to be inserted in the housing from the outside thereof in the card insertion direction. This fact obstructs a high dense mounting operation, by which a number of connectors are mounted densely on one and same board or different boards arranged densely on the same operation plane in sequence or concurrently, from being carried out.

It is desired to provide a connector for a PC card, having a direct push type of a card disengaging mechanism provided therein, improved advantageously in that the number of essential parts to be assembled to form the connector is minimized in order to reduce the cost of the connector, in that handling of the parts is simple and easy in transportation toward a board lying on an operation plane on which the parts are assembled and mounted, in that any extra space other than that occupied by the connector on the board in the operation plane is not required at all to assemble the parts and in that the necessary operation for assembling the parts on the board is simple and easy, in comparison with the conventional connectors.

### Summary of the Invention

A connector for a PC card of the present invention has a direct push type of a card disengaging mechanism provided therein, comprising a connector element; a housing comprising a pair of spaced frames extending in a direction of card insertion/removal, integrated with the connector element at the opposite sides thereof to form a card guiding means between the opposite frames; and a lever having opposite ends to be arranged at the side of the top surface of the connector element with a pivot being located between the opposite ends thereof, one of which ends is raised to form a card pushing means; an ejector to be detachably mounted to the housing, comprising a rod with one end thereof forming a push button means and the other end thereof being linked to the other end of the lever, a space gap open at the side of the top connector element surface being defined between one of the housing frames and the connector element, wherein when the rod is actuated relative to the connector element, the lever is pivotal, while its card pushing means is allowed to pass through said space gap, to thereby have the card pushing means push the PC card directly.

The above featured connector covers a connector disclosed in the above mentioned Japanese Utility Model unexamined publication No. 5-55258. However, the connector of the present invention is different from the prior art connector in that:
1) the ejector further comprises a body having opposite side walls extending in the card insertion/removal direction and a top wall bridging the same, the body being sized so as to fit at the insides of its opposite side walls with both the housing and connector element at the outsides thereof when it is mounted to both the elements from the outside of the top connector element surface;
2) a sleeve means with the rod being slidable therein is integral with one of the opposite side walls of the ejector body at the outside thereof;
3) the lever is pivotal mounted at the pivot thereof to the top wall of the ejector body; and
4) the opposite frames of the housing and the opposite side walls of the ejector body are provided with positioning means for positioning the ejector body relative to the housing in the card insertion/removal direction and détente means for inter-locking the ejector body with the housing when said body mounting from the outside of the housing top wall is effected.

The above mentioned features 1) to 4) in combination enable the connector element integral with the housing mounted in advance on a board lying on a horizontal operation plane to be combined with the ejector composed of the other necessary parts by a single, simple operation for displacing the ejector downwards from a position above the mounted connector element and housing in a vertical direction, to thereby complete the connector mounted on the board. The parts may be designed to allow an operation space required to mount to or combine with the connector element and the housing and also a space occupied by the mounted ejector except for the push button means to become substantially the same as that occupied by the connector element and the housing. Further, the connector element can be transported to the operation plane or location in a form of two separate products: a connector body of the connector element + the housing, which requires a heat insulating property; and the ejector of the ejector body + the lever + the sleeve + the rod, which does not require a heat insulating property.

### Brief Description of the Drawings

The present invention will be described with respect to the accompanying drawing, wherein like numbers refer to like parts in the several views, and wherein:
Fig. 1 is a perspective view showing a connector of the present invention in a mounting and assembling manner, and a PC card in a card inserting process;
Fig. 2 is an exploded perspective view of the connector as shown in Fig. 1;
Fig. 3 is a perspective view of an ejector according to the present invention in an assembled manner;
Fig. 4 is a longitudinally sectional view taken along the line IV-IV in Fig.1;and
Fig. 5 is a longitudinally sectional view taken along the line V-V in Fig. 1.

### Description of the Preferred Embodiment

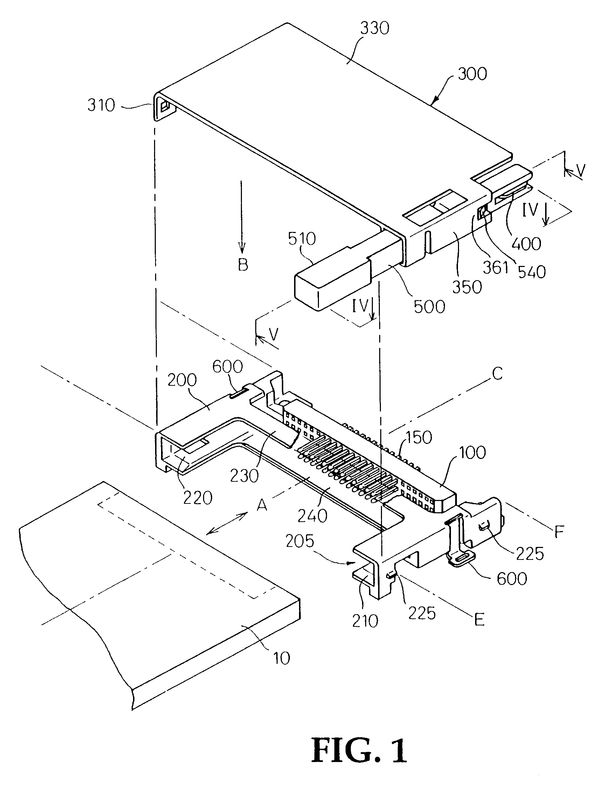

Referring to Figs. 1 to 5, a connector of a PC card according to the present invention is an assembly of only four fundamental parts, that is, a male type of a connector element 100 having a rectangular shape integral with a housing 200, an ejector body 300, a lever 400, and a rod 500, with a pair of optional strain relief tabs 600. The connector element plus housing is called "a connector body" herein. The connector element 100 is provided with a number of terminals 150 in a conventional manner as shown in Fig. 1.

The connector body (100, 200) is of a heat insulating plastic material, and is contoured to be of a profile substantially symmetrical with respect to its center line C extending in a direction A of card insertion/removal direction.

The housing 200 comprises a pair of opposite longitudinal frames 210 spaced from and facing on each other, each having a cross-section of a shape like a letter "I", and a top wall 230 and a bottom wall 240, both bridging the opposite frames. The two frames 210, 220 and both the top and bottom walls 230, 240, in combination, form a card guiding means 205, that is, define a passage for a female type of a PC card 10 on a plane extending in the card insertion/removal direction A. The top wall of the frame 210, 220 and the top wall 230 of the housing are profiled to be spaced from the connector element 100 at the rear edge of the top surface of the rectangular connector element 100, while the bottom wall 240 of the housing in combination with the frames 210, 220 is integrated with the connector element 100 to joint with the connector element at the rear edge of the bottom surface thereof. The opposite frames 210, 220 and the connector element 100 define opposite symmetrical space gaps 250 therebetween, which are open at the top wall 230 of the housing and closed at the bottom wall 240.

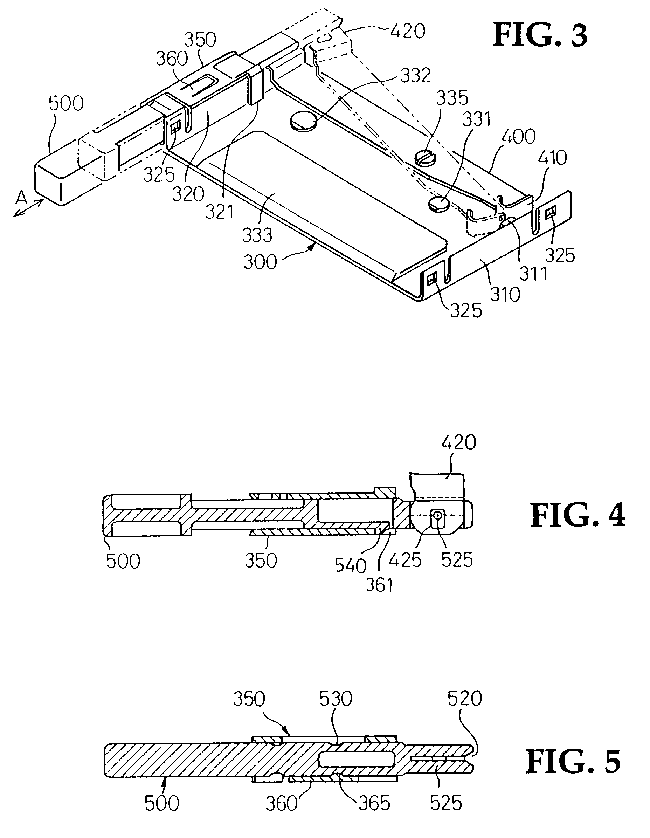

An ejector according to the present invention is completely different from those of the conventional connectors, although the connector body (100, 200) is similar in its basic profile to some of the conventional ones, but with some distinctive modifications made according to the present invention as explained later. The ejector of the present invention is composed of the ejector body 300, the sleeve 350, the rod 500 and the lever 400. The body 330 has a cross-section of a shape like a Japanese letter "I" and is composed of opposite side walls 310, 320 and a top wall 330 bridging both the side walls. The sleeve 350 is designed to allow the rod 500 to slide therein, and is integral with one of the side walls 320 at the outside thereof. The rod 500 is made of a non-heat insulating plastic material, and is of a generally rectangular shape in cross-section and has a push button means 510 formed at its free end and a groove or slot 520 formed at the other end for linking. The groove 520 has a link projection 525 at one of its opposite side surfaces as shown in Figs. 4 and 5. The lever 400 is made of a metal, and is of a generally flat and longitudinal plate, but with its free end being raised or bent to form an abutted surface 410 for the PC card 10 as a card pushing means, and the other end being also raised or bent to form a stepped end 420. The lever 400 has a hole 430 at a pivot located between its opposite ends, and also has another hole 425 at a flat portion of the stepped end 420. In connection with the lever 400, the top wall 330 of the ejector body 300 has a pivot projection 335 at the inside of the wall, which can be snap-fitted with the pivot hole 430 so that the lever is allowed to pivot at the inside of the top wall 330 of the ejector body. The lever 400 is linked with the grooved end of the rod 500 with its stepped end 420 being located at the outside of the frame 210 and disposed in the slot or groove 520 and the link projection 525 being disposed in its link hole 425 with a space gap therebetween large enough to allow it rotate about the pivot defined by the projection 335 and the hole 430, as shown in Figs. 1, 3 and 4.

The ejector composed of the body 300, the sleeve 350 integral thereto, the lever 400 and the rod 500, assembled as above is a product which is able to be handled independently from the connector body (100, 200) as another product.

The ejector body 300 is sized so that its opposite side walls 310, 320 are allowed to fit at their inside surfaces with the corresponding opposite frames 220, 210 of the housing 200 at the outer surfaces thereof, and also it covers the connector body (100, 200) substantially completely at the top side thereof and at the opposite sides thereof, except for leg portions 260, 261 projecting downwards from the connector body provided to abut against a circuit board on which the connector is surface-mounted. The above fitting and covering must be effected when the connector body (100, 200) is disposed in a space defined among its opposite side walls 310, 320 and the top wall 330 of the ejector body 300 with the top wall 230 of the housing 200 facing on the top wall 330 of the ejector body 300 as shown in Fig. 1. Preferably, the ejector body 300 is sized to have its end far from the connector element 100 aligned with a corresponding free end of the housing 200 at the state where it is mounted on the connector body (100, 200) in a predetermined position relative thereto, along a dotted line E as shown in Fig. 1, while the other end of the ejector body 300 is aligned with the other end of the connector body along another dotted line F as shown in Fig. 1.

The opposite side walls 310, 320 of the ejector body 300 and the opposite frames 210, 220 of the housing 200 are provided with positioning means for positioning the ejector body 300 relative to the housing 200 in the card insertion/removal direction A, and détente means for inter-locking the ejector body 300 with the housing 200. Both kinds of means are contemplated to work, when the ejector body 300 is mounted to the connector body from the outside of the housing top wall 230, that is, in a direction B perpendicular to the plane, on which the PC card 10 lies, toward the top wall 230 with the inside surface of the top wall 330 of the ejector body 300 facing on the outside surface of the top wall 230 of the housing 200 as shown in Fig. 1.

The positioning means are composed of elements: lateral groove 211, 221 of the frames 210, 220 formed at the outsides thereof to extend in the lateral direction; and corresponding projections 311, 321 of the ejector frames 310, 320 formed at the insides thereof to extend in the lateral direction. Both the kinds of positioning elements (211, 221; 311, 321) are designed so as to be compatible with each other, respectively, and cooperate to fix a position of the ejector body 300 relative to the housing 200 in the card insertion direction A.

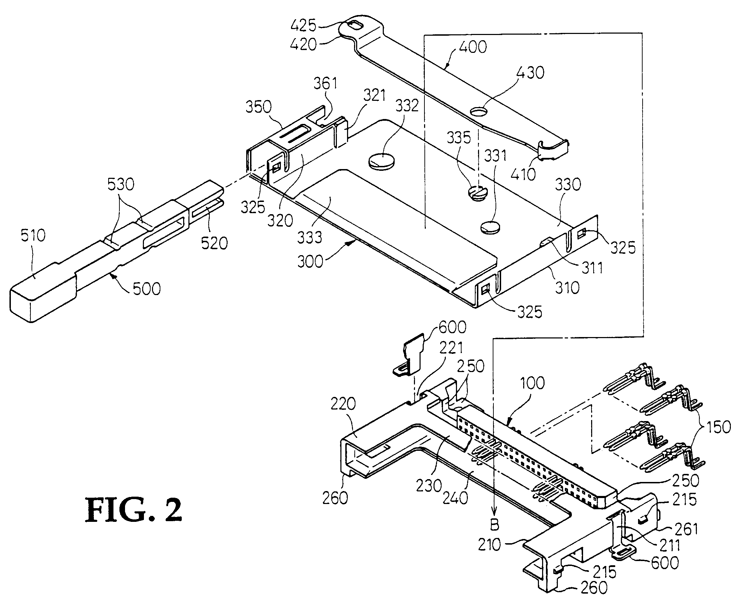

According to the instant embodiment as shown in the drawings, L-shaped tabs 600 of metal are optionally provided in the positioning grooves 211, 221 as shown in Fig. 2 to release strains of the frames 210, 220 of plastics, and work as legs similar to the leg portions 260, 261.

Two detent means are provided at one of the opposite frames 210 of the housing and one of the opposite side walls 320 of the ejector body, while another détente means is provided at the other frame 220 of the housing and the other side wall 310 of the ejector body. This is because the side wall 320 is sized to be shorter by a certain length than the other side wall 310, so that the lever 400 is free enough to cooperate with the rod 500 at the grooved end thereof for pivotal movement of the lever and displacement of the rod along the sleeve 350 without disturbed by the side wall 320 in a region at the outside of the connector element 100. However, according to the present embodiment, the housing 200 is contoured to be symmetrical with respect to the center line C, and thus the frame 210 of the housing, which is symmetrical to the other frame 220, has an additional male latch element. Each detent means is composed of elements; a square hole 325 as a female latch element formed in the side wall 310 or 320 of the ejector body; and a projection 215 as a male latch element formed on the frame 221 or 211 of the housing at the outer side surface thereof. Both the latch elements are designed so as to inter-lock the side wall 310 or 320 of the ejector body with the frame 221 or 210 of the housing.

The top wall 330 of the ejector body has first and second spaced thicker portions or projections 331, 332 at its inside surface. The first thicker portion 331 is provided to stop a pivotal movement of the lever 400 in a direction in which the PC card 10 is pushed, while the second thicker portion 332 is provided to stop another pivotal movement of the lever in the opposite direction. Of course, a single thicker portion of the top wall 330 may be designed to exert such a double stopping function for the opposite pivotal movements of the lever 400.

The top wall 330 of the ejector body 300 also have a larger, thicker portion 333 profiled so as to be able to fit with at least both the frames 210, 220 at the inner side edges, particularly at the inner edges of the frame top walls at the state where the ejector body is mounted to the connector body (100, 200) in a fixed position relative thereto. The third larger, thicker portion 333 prevents the housing 200 from being deflected laterally with respect to the card insertion/removal direction A, and enables both the ejector body 300 and the housing 200 to be reinforced by each other.

According to the present embodiment, the third thicker portion 333 is profiled to also fit with the housing top wall 230 at the rear edge thereof. This enhances the above two kinds of effects due to the fitting. The third thicker portion 333 has a flat end surface being positioned below a level of the inner wall surface of the housing top wall 230 or preferably being flush with the inner wall surface.

The sleeve 350 is of a rectangular shape formed by top and bottom walls and opposite side walls to allow the rectangular rod 500 to extend therethrough, and the bottom wall of the sleeve 350 has a cut-away portion 361 at its forward end nearer to the connector element, while the rod 500 has a hook 540. The hook 540 is engaged with the inner edge of the cut-away portion 361 as shown in Fig. 4 to stop further retraction of the rod 500, when the rod arrives at a fixed withdraw position. The rod 500 has two spaced lateral grooves 530 at its bottom surface, while the bottom wall of the sleeve 350 is cut away to form a cantilever portion 360 of a U shape, and has a projection 365 formed at the inside thereof. The projection 365 of the sleeve cooperates with each groove 530 of the rods to impart a click feeling to an operator when the rod is actuated by his figure. The push button means 510 of the rod is stepped so as to be enlarged relative to the forward portion of the rod, and is sized to stop the advancing movement of the rod at the step when the rod 500 is in a fixed advance position, where the first thicker portion or projection 331 formed at the top wall 330 of the ejector body synchronously stops the pivotal movement of the lever 400, as previously explained.

According to the present embodiment, although the present invention is not limited to the embodiment, any spring means for forcing the rod 500 to return to the withdrawal position is not used. Therefore, an advance position of the rod where the PC card 10 has been pushed out or ejected from the rear end of the ejector body 300 by the lever 400 having disengaged the female PC card from the male connector element 100 as a result of advance of the rod, is maintained as it is. However, when a next PC card is inserted to engage with the connector element, the lever is pivoted in the reverse direction by a force applied to insert the card with the forward end of the card abutting against the card pushing means 410 of the lever. The rod thus is returned from the advance position to the withdrawal position, when the card is completely engaged with the connector element.

According to the present embodiment, the housing 200 is provided with the top wall 230. However, in a case where the degree of necessity of the top wall as a connector element protecting cover is low, the top wall of the housing may be omitted. This is because the present invention does not require the lever 400 to be pivotal mounted to the housing wall 230, contrary to that in the conventional connector, and enables the top wall 330 of the ejector body 300 to cover the connector element 100 completely, when the ejector body is mounted to the connector body, with the ejector body 300 having the opposite side walls 310, 320 and the top wall 330, and the housing 200 reinforcing each other.

Although the detent means in the instant embodiment is composed of male and female elements: the latch projects (215, 225) formed on the housing frames at the side walls thereof, and the latch holes (315, 325) formed in the ejector body at the side walls thereof, the present invention is not limited to this embodiment and allows various modifications to be adopted. For example, the housing frame 210, 220 may be modified to have their side walls formed to have outer surface curved to project outwards, while the side walls 310, 320 of the ejector body are modified to be compatible walls curved to project outwards,, so that both kinds of walls can be fitted with each other mainly due to the elasticity of the body side walls. In this modified case, the housing frames and the side walls of the ejector body form in combination detent means for inter-lock them in the vertical direction B. If the modified detent means are applied in combination with the above embodied positioning means (211, 221; 311, 321), both kinds of means enable the ejector body to be inter-locked with the housing in both the directions A and B

According to the present embodiment, the connector body (100, 200) is symmetrical with respect to the center line C as shown in the drawings, and thus mirror-symmetrical ejectors, i.e., a left type as illustrated and a right type (not shown), may be applied alternatively with the illustrated common connector body as needed.

According to the present invention, provided is a connector with the number of the necessary parts being minimized, which is useful in practice in that it can be handled in a form of the connector body (100, 200) of a heat insulating material and the ejector (300, 400, 500) prepared as two separate products, and both the products enable the ejector to be mounted to the connector body mounted in advance on a circuit board with a simple operation requiring only one snap action and enable a high dense on-board mounting of multiple connectors to be effected on a common operation plane.

## Claims

1. A connector for a PC card having a direct push type of a card disengaging mechanism provided therein, comprising a connector element (100); a housing (200) comprising a pair of spaced frames (210, 220) extending in a direction (A) of card insertion/removal, integrated with the connector element at the opposite sides thereof to form a card guiding means (205) between the opposite frames; and a lever (400) having opposite ends to be arranged at the side of the top surface of the connector element with a pivot being located between the opposite ends thereof, one of which ends is raised to form a card pushing means (410); an ejector to be detachably mounted to the housing, comprising a rod (500) with one end thereof forming a push button means (510) and the other end thereof being linked to the other end of the lever, a space gap (250) open at the side of the top connector element surface being defined between one of the housing frames and the connector element, wherein when the rod is actuated relative to the connector element, the lever (400) is pivotal, while its card pushing means (410) is allowed to pass through said space gap (250), to thereby have the card pushing means push the PC card directly, characterized in that:
1) the ejector further comprises a body (300) having opposite side walls (310, 320) extending in the card insertion/removal direction (A) and a top wall (330) bridging the same, the body being sized so as to fit at the insides of its opposite side walls with both the housing (200) and connector element (100) at the outsides thereof when it is mounted to both the elements (100, 200) from the outside of the top connector element-surface;
2) a sleeve means (350) with the rod (500) being slidable therein is integral with one of the opposite side walls (320) of the ejector body at the outside thereof;
3) the lever (400) is pivotally mounted at the pivot (335, 430) thereof to the top wall (330) of the ejector body; and
4) the opposite frames (210, 220) of the housing and the opposite side walls (310, 320) of the ejector body are provided with positioning means (211, 221; 321, 311) for positioning the ejector body (300) relative to the housing (200) in the card insertion/removal direction (A) and détente means (215, 225; 325, 315) for interlocking the ejector body with the housing when said body mounting from the outside of the housing top wall is effected.

2. A connector according to claim 1, wherein the top wall (330) of the ejector body has a thicker portion (333) profiled to be able to fit with both the housing frames (210, 220) at the insides thereof at the state of said body mounting.

3. A connector according to claim 1 or 2, wherein the top wall (330) of the ejector body has at least one thicker portion (331, 332) provided to stop pivotal movements of the lever (400) in opposite directions.

4. A connector according to any one of claims 1 to 3, wherein the ejector body (300)is sized to have its end far from the connector element (100) aligned with a corresponding free end of the housing (200) at the state of said body mounting.
